# FASCICULE DE BREVET EUROPEEN

(11) **EP 3 651 215 B1**
(45) Date de publication et mention de la délivrance du brevet: **30.12.2020**
(21) Numéro de dépôt: 19208132.1
(22) Date de dépôt: 08.11.2019
(51) Int. Cl.: H01L 31/119, H01L 31/115, H01L 27/144, H01L 29/786

(54) **DÉTECTEUR DE RAYONNEMENTS IONISANTS**
DETEKTOR FÜR IONISIERENDE STRAHLUNG
IONISING RADIATION DETECTOR

(30) Priorité: 12.11.2018 FR 1871486
(43) Date de publication de la demande: 13.05.2020
(73) Titulaire: STMicroelectronics (Crolles 2) SAS, 38920 Crolles (FR)
(72) Inventeur: GASIOT, Gilles, 38170 SEYSSINET-PARISET (FR); ABOUZEID, Fady, 38660 LA TERRASSE (FR)
(74) Mandataire: Cabinet Beaumont

(56) Documents cités:
- EP-A1- 0 543 745
- JP-A- S59 132 673
- US-A- 3 452 206
- US-A1- 2009 113 357

## Description

### Domaine technique

La présente description concerne de façon générale les dispositifs électroniques, notamment les circuits intégrés, et en particulier un détecteur de rayonnements ionisants.

### Technique antérieure

Certains circuits intégrés permettent la détection de rayonnements ionisants. Les rayonnements ionisants sont généralement constitués ou issus de particules à haute énergie, c'est-à-dire supérieure à quelques eV, par exemple supérieure à environ 13 eV, le plus souvent supérieure à 1 keV, voire supérieure à 1 MeV. Ces particules sont typiquement des protons, des neutrons ou des particules alpha. Le document US 3452206 A divulgue un détecteur de radiations à jonction PN, et le document JP S59 132673 A divulgue un transistor de type MOS comprenant une jonction PN.

### Résumé de l'invention

Un mode de réalisation pallie tout ou partie des inconvénients des détecteurs connus de rayonnements ionisants.

Un mode de réalisation pallie tout ou partie des inconvénients des circuits intégrés connus.

Un mode de réalisation prévoit un détecteur de rayonnements ionisants comprenant un ou plusieurs dispositifs comprenant une diode et un transistor connectés en parallèle, deux régions de drain/source du transistor étant reliées respectivement aux bornes de la diode, le transistor étant situé sur une couche électriquement isolante recouvrant une première région située sous la couche isolante, la première région formant une jonction PN de la diode avec une deuxième région située sous la première région.

Selon un mode de réalisation, le transistor comprend une région de canal, les deux régions de drain/source étant situées de part et d'autre de la région de canal, la région de canal et les régions de drain/source étant sur et en contact avec la couche électriquement isolante.

Selon un mode de réalisation, le transistor est à canal N et la première région est dopée de type N.

Selon un mode de réalisation, le dispositif comprend un substrat semiconducteur dont une partie définit la deuxième région, et un caisson dopé dont une partie définit la première région.

Selon un mode de réalisation, ledit caisson comprend une portion s'étendant en dehors de l'aplomb du transistor.

Selon un mode de réalisation, la diode de l'un desdits dispositifs est reliée à une grille du transistor d'un autre desdits dispositifs.

Selon un mode de réalisation, chacun desdits dispositifs comprend un inverseur comprenant un desdits transistors.

Selon un mode de réalisation, lesdits inverseurs sont reliés en série.

Un mode de réalisation prévoit un procédé de détection d'un rayonnement ionisant, comprenant l'utilisation d'un détecteur tel que défini ci-dessus.

Ce procédé de détection comprend la génération d'un courant à travers la jonction PN par le rayonnement ionisant.

Selon un mode de réalisation, le procédé comprend la comparaison à un seuil d'une tension entre des bornes du transistor.

Selon un mode de réalisation, ladite comparaison comprend l'utilisation d'un autre dispositif tel que défini ci-dessus.

Selon un mode de réalisation, le transistor dudit autre dispositif est commandé par ladite tension.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 représente une vue 1A schématique en coupe et un schéma 1B d'un mode de réalisation d'une cellule de détection de rayonnements ionisants ; et

la figure 2 représente de manière partielle et schématique un mode de réalisation d'un détecteur de rayonnements ionisants.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, des circuits d'application d'un niveau logique et de détection d'un changement temporaire de niveau logique ne sont pas détaillés, les modes de réalisation décrits étant compatibles avec les circuits logiques usuels d'applications d'un niveau logique et de détection d'un changement temporaire de niveau logique. En outre, les procédés de réalisation de structures de transistors à grille arrière, et de liaisons entre ces transistors, ne sont pas décrits en détail, les modes de réalisation décrits étant compatibles avec les procédés usuels de réalisation de telles structures et liaisons.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Sauf précision contraire, lorsque l'on fait référence à des éléments identiques, cela signifie identiques à la précision près de leur procédé de réalisation.

Dans la présente description, lorsque l'on fait référence à des qualificatifs de position absolue, tels que les termes "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

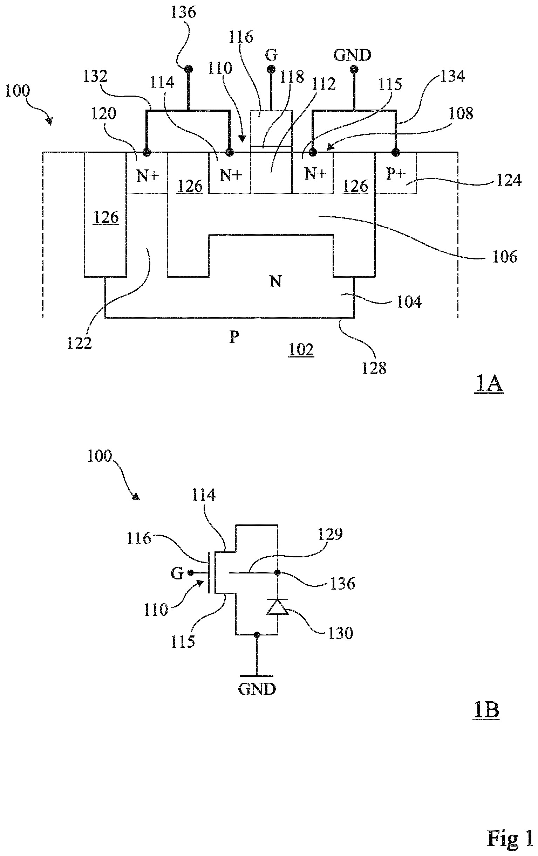

La figure 1 représente une vue 1A schématique en coupe et un schéma 1B d'une cellule 100 de détection de rayonnements ionisants.

La cellule 100 est comprise dans un détecteur de rayonnements ionisants. Le détecteur comprend une cellule 100 ou, de préférence, plusieurs cellules 100. Les cellules 100 sont alors de préférence similaires ou identiques. Le détecteur est par exemple utilisé pour des rayonnements ionisants d'origine spatiale, typiquement dans un satellite, notamment dans un satellite de communication tel qu'un satellite utilisé pour le réseau Internet.

De préférence, le détecteur est compris dans une puce électronique de circuit intégré. La puce électronique comprend un substrat semiconducteur 102, de préférence en silicium, par exemple dopé de type P. La cellule 100 est alors de préférence formée au moins en partie dans et sur une face avant (face supérieure) du substrat 102.

A titre d'exemple, la puce électronique est de type système sur puce SOC ("System On Chip"). Des puces de type SOC sont utilisées notamment dans des applications embarquées ou mobiles, en particulier dans le transport ou des applications spatiales. Une puce de type SOC comprend typiquement une unité de traitement séquentiel de données, par exemple de type microprocesseur, et divers périphériques tels que des mémoires et/ou des interfaces de communication numérique avec l'extérieur de la puce.

La cellule 100 comprend une région dopée 104 définie par un caisson, par exemple dopé de type N, situé du côté de la face avant du substrat 102. La région 104 est au moins en partie située sous une couche électriquement isolante 106, par exemple en oxyde de silicium. La couche 106 est de préférence en contact avec la région 104. Une portion de couche semiconductrice 108, par exemple en silicium, est située à l'aplomb de la région 104. La couche semiconductrice 108 recouvre la couche isolante 106. La cellule 100 résulte alors de préférence d'un procédé de fabrication à partir d'une structure de type semiconducteur sur isolant SOI ("Semiconductor On Insulator"), c'est à dire une structure comprenant le substrat 102, la couche isolante 106 recouvrant le substrat 102, et la couche semiconductrice 108 sur la couche isolante 106.

Un transistor 110 est situé dans et sur la couche semiconductrice 108. A titre d'exemple, le transistor 110 comprend une région de canal 112, des régions de drain/source 114 et 115 de part et d'autre de la région de canal 112, et une grille isolée 116 disposée sur la région de canal 112. La grille 116 correspond à un nœud G de commande du transistor. Les régions 114 et 115 sont de préférence en contact avec la couche isolante 106. A titre d'exemple, les régions 114 et 115 sont dopées du même type de conductivité que le caisson 104 (ici de type N). La région de canal 112 est alors par exemple dopée de type P. Les régions 114 et 115 ont de préférence des niveaux de dopage élevés (N+), par exemple supérieurs à celui de la région 104.

La cellule 100 comprend de préférence une prise de contact 120 avec la région 104. De préférence, la région 104 définit alors une grille arrière 129 (schéma 1B) du transistor 110. La prise de contact 120 comprend de préférence une zone plus fortement dopée (N+) que la région 104. De préférence, la prise de contact 120 est située sur et en contact avec un prolongement 122 de la région 104 qui s'étend en dehors de l'aplomb du transistor 110.

La cellule comprend en outre de préférence une prise de contact 124 avec le substrat 102. La prise de contact 124 comprend de préférence une zone plus fortement dopée (P+) que le substrat 102.

Le transistor 110 et les prises de contact 120 et 124 sont de préférence délimités et séparés par des tranchées d'isolement 126, par exemple de type STI ("Shallow Trench Isolation"). De préférence, les tranchées d'isolement entourent la prise de contact 120 et le transistor 110. Les tranchées d'isolement 126 s'étendent de la face avant jusqu'à un niveau situé dans la région 104. De préférence, les tranchées d'isolement 126 s'étendent jusqu'à un niveau situé en dessous du niveau inférieur de la couche 106.

La région dopée 104 forme avec la région du substrat située sous elle une jonction PN 128 d'une diode 130 (schéma 1B). La diode 130 a des électrodes définies par les régions 102 et 104. La diode a des bornes définies par les prises de contact 120 et 124. La jonction PN 128 s'étend horizontalement sous le transistor 110. La région de canal 112 du transistor 110 est entièrement située à l'aplomb de la jonction PN 128. De préférence, les régions de drain/source 114 et 115 sont entièrement situées à l'aplomb de la jonction PN 128.

La région de drain/source 114 du transistor 110 est reliée à la région 104, de préférence connectée à la prise de contact 120, par une liaison électriquement conductrice 132, par exemple métallique. La région de drain/source 115 du transistor 110 est reliée au substrat 102, de préférence connectée à la prise de contact 124, par une liaison électriquement conductrice 134, par exemple métallique. Le transistor 110 et la diode 130 sont ainsi connectés électriquement en parallèle. La liaison 132 relie, de préférence connecte, la prise de contact 120 et la région 114 à un nœud 136. A titre d'exemple, la liaison 134 relie, de préférence connecte, la prise de contact 124 et la région 115 à un nœud d'application d'un potentiel de référence GND tel que la masse.

A titre d'exemple, la puce comprend, outre la ou les cellules 100, des structures identiques ou similaires à celle formée par les éléments de la cellule 100 autres que les liaisons 132 et 134. Dans cet exemple, chacune de ces structures correspond à un transistor (ici de type MOS à canal N) comprenant une grille arrière. De préférence, la prise de contact 124 est commune à plusieurs de ces transistors à grille arrière. La prise de contact 120 et la région 104 sont par exemple communes à plusieurs des transistors à grille arrière. La puce comprend en outre des liaisons électriquement conductrices entre les transistors à grille arrière.

La ou les cellules 100 peuvent alors être réalisées en même temps et par des mêmes étapes de fabrication que les transistors à grille arrière et les liaisons entre ces transistors. Ceci permet d'obtenir les cellules 100 sans ajouter d'étape à la fabrication des transistors à grille arrière et des liaisons entre ces transistors. En outre, la mise en oeuvre de cette fabrication peut être faite à partir d'une structure de type SOI.

Du fait que la jonction PN 128 est située sous le transistor, la cellule 100 occupe une surface de la puce inférieure à celle d'une cellule de détection de rayonnements ionisants qui comprendrait une diode et un transistor situés à des emplacements différents.

En fonctionnement, le nœud 102 est de préférence relié à un nœud d'application d'un potentiel positif par un élément résistif non représenté en figure 1, par exemple un transistor de type MOS à canal P. Une particule d'un rayonnement ionisant traversant le transistor est susceptible de produire un courant temporaire circulant de la région de drain 114 vers la région de source 115. Ceci provoque une diminution temporaire de la tension aux bornes du transistor 110. Cette tension correspond au potentiel du nœud 136. On détecte la diminution de tension aux bornes du transistor 110 par exemple en comparant la valeur du potentiel du nœud 136 à un seuil. De préférence, le seuil correspond à une valeur de potentiel située entre des niveaux logiques haut et bas. On détecte ainsi le passage de la particule dans la cellule.

Du fait que la jonction PN 128 est située sous le transistor 110, la particule traverse aussi la jonction PN 128. Ceci provoque temporairement la circulation d'un courant à travers la jonction PN 128 de la région N 104 vers le substrat P 102. Ce courant provoque une diminution supplémentaire du potentiel du nœud 136. On augmente ainsi la probabilité de détecter le passage de la particule, c'est-à-dire la sensibilité de détection. Ainsi, du fait de la présence de la diode 130, la cellule 100 est plus sensible qu'une cellule comprenant seulement un transistor.

De plus, la cellule 100 est plus sensible qu'une cellule comprenant une diode et dépourvue d'un transistor sur la diode. Ceci provient du fait que, dans la cellule 100, l'effet sur le potentiel du nœud 136 du courant dans le transistor 110 s'ajoute à l'effet du courant dans la diode 130.

En outre, dans l'exemple représenté où la cellule 100 est obtenue à partir d'une structure de type SOI, la couche semiconductrice 108 a une épaisseur par exemple inférieure à environ 25 nm, de préférence de l'ordre de 7 nm. Dans la jonction PN 128, le courant provoqué par la particule provient de charges générées de part et d'autre de la jonction PN 128 dans une région d'épaisseur supérieure à celle de la couche 108. Le volume de détection du rayonnement ionisant est ainsi plus élevé dans la cellule 100 que dans une cellule comprenant seulement un transistor dans et sur une structure de type SOI. Ainsi, la cellule est beaucoup plus sensible, par exemple plus de 100 fois plus sensible, voire plus de 500 fois plus sensible, qu'une cellule comportant seulement un transistor dans et sur une structure de type SOI.

En outre, une particule de rayonnement ionisant peut provoquer un courant circulant temporairement du prolongement 122 de la région 104 vers le substrat 102. Ainsi, le prolongement 122 contribue à la sensibilité de la cellule 100. La cellule 100 est ainsi particulièrement sensible.

A titre d'exemple, la grille du transistor a une largeur comprise entre 10 nm et 200 nm. La couche isolante 106 a une épaisseur par exemple comprise entre 10 nm et 300 nm. La hauteur de la partie de la région 104 située sous la couche 106 est par exemple comprise entre 0,5 µm et 5 µm.

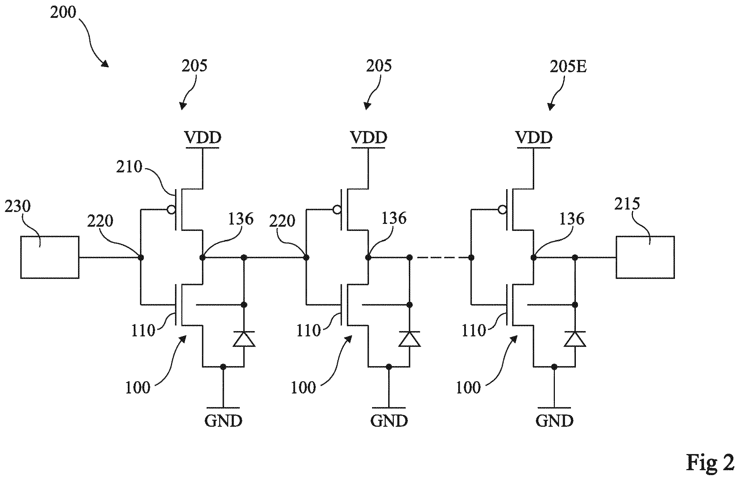

La figure 2 représente de manière partielle et schématique un détecteur 200 de rayonnements ionisants.

Le détecteur comprend plusieurs inverseurs 205, 205E reliés, de préférence connectés, en série. Trois inverseurs sont représentés, mais le détecteur peut comprendre tout nombre d'inverseurs, par exemple plus de dix inverseurs, de préférence plus de 100 inverseurs, voire plus de 1000 inverseurs.

Chaque inverseur 205, 205E comprend une cellule 100 décrite en relation avec la figure 1. De préférence, la prise de contact 124 est commune à plusieurs des cellules 205, 205E. La prise de contact 120 et la région 104 sont par exemple communes à plusieurs des cellules 205, 205E.

Dans chaque inverseur 205, 205E, le nœud 136 de la cellule 100 est relié par un élément résistif à un nœud d'application d'un potentiel positif VDD. L'élément résistif est de préférence un transistor 210 à effet de champ à canal P. Dans chaque inverseur 205, 205E, les grilles du transistor 210 et du transistor 110 sont reliées, de préférence connectées, ensemble à un nœud 220 d'entrée de l'inverseur. Dans chaque inverseur 205, 205E, le nœud 136 constitue un nœud de sortie de l'inverseur. La sortie de chaque inverseur 205 de l'association série autre que le dernier inverseur 205E de l'association série est reliée à l'entrée de l'inverseur 205 suivant. La sortie du dernier inverseur 205E de l'association série est reliée à un circuit 215 de détection d'un changement temporaire de niveau logique. Le nœud 220 d'entrée du premier inverseur 205 de l'association série est relié à un circuit 230 fournissant sur ce nœud un niveau logique, par exemple un niveau logique bas.

En fonctionnement, lorsqu'une particule de rayonnement ionisant traverse l'une des cellules 100, le potentiel du nœud 136 de cette cellule par exemple diminue temporairement. Lorsque ce potentiel est inférieur à une valeur de seuil définie par les tensions de seuil des transistors 210 et 110 de la cellule suivante, le niveau logique de la cellule suivante change. Le changement temporaire de niveau logique est transmis par les inverseurs 205 connectés en série jusqu'au circuit 215 qui détecte ce changement de niveau logique. On détecte ainsi le passage de la particule. On peut ensuite par exemple compter une fréquence moyenne de détection, correspondant à une intensité du rayonnement ionisant.

Du fait que le transistor 110 de chaque cellule 100 est commandé par le potentiel de sortie de la cellule précédente, l'association série des cellules 100 transmet jusqu'au circuit 215 un changement de niveau logique de n'importe laquelle des cellules 100. On pourrait transmettre à un circuit de détection un changement de niveau logique de n'importe laquelle de plusieurs cellules de détection, par des liaisons reliant ces cellules indépendamment les unes des autres au circuit de détection. Cependant, la réalisation de l'association série des cellules 100 du détecteur 200 est plus simple que la réalisation de telles liaisons indépendantes.

De préférence, les inverseurs sont similaires ou identiques. Le détecteur peut ainsi être conçu et réalisé de manière particulièrement simple.

A titre de variante, on peut remplacer les inverseurs 205, 205E du détecteur 200 par tout circuit logique adapté à transmettre vers une sortie un changement de niveau logique sur une entrée, ce circuit logique comprenant au moins une cellule 100 configurée pour changer le niveau logique de la sortie lorsque cette cellule 100 détecte une particule de rayonnement ionisant. Un tel circuit peut en particulier être une porte logique NON OU.

Divers modes de réalisation et variantes ont été décrits. L'homme de l'art comprendra que certaines caractéristiques de ces divers modes de réalisation et variantes pourraient être combinées, et d'autres variantes apparaitront à l'homme de l'art. En particulier, dans les modes de réalisation décrits ci-dessus, on peut échanger les types N et P de conductivité et les potentiels hauts et bas, en particulier les potentiels VDD et GND.

Enfin, la mise en oeuvre pratique des modes de réalisation et variantes décrits est à la portée de l'homme du métier à partir des indications fonctionnelles données ci-dessus.

## Revendications

1. Détecteur de rayonnements ionisants comprenant un ou plusieurs dispositifs comprenant une diode (130) et un transistor (110), **caractérisé en ce que** la diode (130) et le transistor (110) sont connectés en parallèle, deux régions de drain/source du transistor étant reliées respectivement aux bornes de la diode, le transistor étant situé sur une couche électriquement isolante (106) recouvrant une première région (104) située sous la couche isolante, la première région (104) formant une jonction PN (128) de la diode avec une deuxième région (102) située sous la première région.

2. Détecteur selon la revendication 1, dans lequel le transistor (110) comprend une région de canal (112), les deux régions de drain/source (114, 115) étant situées de part et d'autre de la région de canal, la région de canal et les régions de drain/source étant sur et en contact avec la couche électriquement isolante (106).

3. Détecteur selon la revendication 1 ou 2, dans lequel le transistor (110) est à canal N et la première région (104) est dopée de type N.

4. Détecteur selon l'une quelconque des revendications 1 à 3, comprenant un substrat semiconducteur (102) dont une partie définit la deuxième région, et un caisson dopé dont une partie définit la première région (104).

5. Détecteur selon la revendication 4, dans lequel ledit caisson (104) comprend une portion (122) s'étendant en dehors de l'aplomb du transistor.

6. Détecteur selon l'une quelconque des revendications 1 à 5, dans lequel la diode (130) de l'un desdits dispositifs est reliée à une grille (116) du transistor (110) d'un autre desdits dispositifs.

7. Détecteur selon la revendication 6, dans lequel chacun desdits dispositifs comprend un inverseur (105, 105E) comprenant un desdits transistors (110).

8. Détecteur selon la revendication 7, dans lequel lesdits inverseurs (105, 105E) sont reliés en série.

9. Procédé de détection d'un rayonnement ionisant, comprenant l'utilisation d'un détecteur selon l'une quelconque des revendications 1 à 8, dans lequel un courant est généré à travers la jonction PN (128) par le rayonnement ionisant.

10. Procédé selon la revendication 9, comprenant la comparaison à un seuil d'une tension entre des bornes du transistor (110) .

11. Procédé selon la revendication 9, comprenant la comparaison à un seuil d'une tension entre des bornes du transistor de l'un desdits plusieurs dispositifs, ladite comparaison comprenant l'utilisation d'un autre desdits plusieurs dispositifs.

12. Procédé selon la revendication 11, dans lequel le transistor (110) dudit un autre desdits plusieurs dispositifs est commandé par ladite tension.

## Patentansprüche

1. Detektor für ionisierende Strahlung mit einem oder mehreren Bauelementen aufweisend eine Diode (130) und einen Transistor (110), **dadurch gekennzeichnet, dass** die Diode (130) und der Transistor (110) parallel geschaltet sind, zwei Drain/Source-Bereiche des Transistors jeweils mit den Anschlüssen der Diode gekoppelt sind, der Transistor auf einer elektrisch isolierenden Schicht (106) angeordnet ist, die einen ersten Bereich (104) bedeckt, der unter der isolierenden Schicht liegt, wobei der erste Bereich (104) einen PN-Übergang (128) der Diode bildet mit einem zweiten Bereich (102), der unter dem ersten Bereich liegt.

2. Detektor nach Anspruch 1, wobei der Transistor (110) einen Kanalbereich (112) aufweist, wobei die beiden Drain/Source-Bereiche (114, 115) auf beiden Seiten des Kanalbereichs angeordnet sind, wobei der Kanalbereich und die Drain/Source-Bereiche auf der elektrisch isolierenden Schicht (106) liegen und mit dieser in Kontakt stehen.

3. Detektor nach Anspruch 1 oder 2, wobei der Transistor (110) einen N-Kanal aufweist und der erste Bereich (104) N-Typ dotiert ist.

4. Detektor nach einem der Ansprüche 1 bis 3, aufweisend ein Halbleitersubstrat (102) mit einem Abschnitt, der den zweiten Bereich definiert, und mit einer dotierten Wanne (104) mit einem Abschnitt, der den ersten Bereich definiert.

5. Detektor nach Anspruch 4, wobei die Wanne (104) einen Abschnitt (122) aufweist, der sich außerhalb des Bereichs erstreckt, der vertikal mit dem Transistor ausgerichtet ist.

6. Detektor nach einem der Ansprüche 1 bis 5, wobei die Diode (130) eines der Bauelemente mit einem Gate (116) des Transistors (110) eines anderen der Bauelemente gekoppelt ist.

7. Detektor nach Anspruch 6, wobei jedes der Bauelemente einen Inverter (105, 105E) mit einem der Transistoren (110) aufweist.

8. Detektor nach Anspruch 7, wobei die Inverter (105, 105E) in Reihe geschaltet sind.

9. Verfahren zum Detektieren von ionisierender Strahlung, aufweisend die Verwendung der Vorrichtung nach einem der Ansprüche 1 bis 8, wobei durch die ionisierende Strahlung ein Strom über den PN-Übergang (128) erzeugt wird.

10. Verfahren nach Anspruch 9, aufweisend den Vergleich eines Schwellenwerts mit einer Spannung über den Transistor (110).

11. Verfahren nach Anspruch 9, aufweisend den Vergleich eines Schwellenwerts mit einer Spannung zwischen den Anschlüssen des Transistors eines der Bauelemente, wobei der Vergleich die Verwendung eines anderen der Bauelemente aufweist.

12. Verfahren nach Anspruch 11, wobei der Transistor (110) des anderen der Bauelemente durch die Spannung gesteuert wird.

## Claims

1. An ionizing radiation detector comprising one or more devices comprising a diode (130) and a transistor (110), **characterized in that** the diode (130) and the transistor (110) are connected in parallel, two drain/source regions of the transistor being respectively coupled to the terminals of the diode, the transistor being located on an electrically-insulating layer (106) covering a first region (104) located under the insulating layer, the first region (104) forming a PN junction (128) of the diode with a second region (102) located under the first region.

2. The detector of claim 1, wherein the transistor (110) comprises a channel region (112), the two drain/source regions (114, 115) being located on either side of the channel region, the channel region and the drain/source regions being on top of and in contact with the electrically-insulating layer (106).

3. The detector of claim 1 or 2, wherein the transistor (110) has an N channel and the first region (104) is N-type doped.

4. The detector of any of claims 1 to 3, comprising a semiconductor substrate (102) having a portion defining the second region, and a doped well (104) having a portion defining the first region.

5. The detector of claim 4, wherein said well (104) comprises a portion (122) extending outside of the location vertically in line with the transistor.

6. The detector of any of claims 1 to 5, wherein the diode (130) of one of said devices is coupled to a gate (116) of the transistor (110) of another one of said devices.

7. The detector of claim 6, wherein each of said devices comprises an inverter (105, 105E) comprising one of said transistors (110).

8. The detector of claim 7, wherein said inverters (105, 105E) are coupled in series.

9. An ionizing radiation detection method, comprising using the device of any of claims 1 to 8, wherein a current is generated across the PN junction (128) by the ionizing radiation.

10. The method of claim 9, comprising comparing with a threshold a voltage across the transistor (110).

11. The method of claim 9, comprising comparing with a threshold a voltage between the terminals of the transistor of one of the devices, the comparing comprising using another one of the devices.

12. The method of claim 11, wherein the transistor (110) of said another one of the devices is controlled by said voltage.
